# EUROPEAN PATENT SPECIFICATION

(11) **EP 2 622 654 B1**
(45) Date of publication and mention of the grant of the patent: **05.05.2021**
(21) Application number: 11828190.6
(22) Date of filing: 12.09.2011
(51) Int. Cl.: H01L 33/64, H01L 23/36, H01L 23/373, H05K 7/20, H01L 25/075

(54) **METHOD FOR MANUFACTURING OF AN ELECTRIC ACTUATOR**
VERFAHREN ZUR HERSTELLUNG EINES ELEKTRISCHEN AKTUATORS
PROCÉDÉ DE FABRICATION D'UN ACTIONNEUR ÉLECTRIQUE

(30) Priority: 28.09.2010 FI 20106001
(43) Date of publication of application: 07.08.2013
(73) Proprietor: Coolics Oy, 33840 Tampere (FI)
(72) Inventor: KANERVISTO, Jari, FI-33710 Tampere (FI)
(74) Representative: Kangasmäki, Reijo Holger
(86) International application number: PCT/FI2011/050781
(87) International publication number: WO 2012/042100

(56) References cited:
- EP-A1- 2 020 683
- WO-A2-2009/008636
- DE-A1-102008 045 925
- JP-A- 2003 324 215
- US-A1- 2002 176 259
- US-A1- 2006 018 608
- US-A1- 2007 262 328
- US-A1- 2008 220 547
- US-A1- 2010 155 748

## Description

A method for manufacturing of an electric actuator, which actuator consists of an electric actuator arrangement that is sensible to heat and/or that generates heat, the actuator being put together to form a uniform organ, such as a light source, by coupling the electric actuator arrangement with an at least thermally conductive frame part.

Particularly e.g. in LED-lighting/light production putting together of the type of light sources described above is nowadays a problem, since the production is still based on e.g. manual manufacturing, wherein a separate LED component is being glued or fastened by a screw joint e.g. to an aluminium based frame part. When using a screw joint, between the LED component and the aluminium frame is usually installed furthermore a thermally conductive paste or tape. This kind of an intermediate layer is required due to the fact that the surface of aluminium is not totally level, which is why, despite the screw joint, there will be left air between the parts, which weakens thermal transmission. The thermally conductive paste or tape levels the surface roughness of the aluminium and forms a uniform heat transmitting substance layer between the parts in question. In this kind of an implementation, the aluminium frame acts thus as an element that cools the LED, in which connection it is characteristic that the better the cooling is at the back side of the LED, the brighter the LED illuminates thus also enabling as long as possible operating time thereof. An advantage of aluminium, being used as a part of the frame material, is its property of having a good thermal conductivity, whereby aluminium has a disadvantage first of all due to its thermal expansion and on the other hand due to its electric conductivity and even "extensive" thermal conductivity (high surface temperature) in certain implementations. Furthermore, aluminium needs usually to be separately painted or coated in order to prevent it from becoming oxidized.

Document EP 2 020 683 discloses a method for manufacturing of an electric actuator, which electric actuator consist of an electric actuator arrangement, being sensible to heat and/or generating heat and comprising one or several light emitting electric actuators such as LEDs. The electric actuator is being put together to form a uniform organ, such as a light source, and comprising a frame that exist against a heat exchange surface of the electric actuator arrangement, which is placed at least partly inside the frame part.

Furthermore document JP 2003 324215 discloses an integral electric actuator with a light emitting diode, wherein the frame part of the device is being made of an at least thermally conductive composite material that makes possible cooling of the light emitting diode. Another prior art is disclosed in the document US2010/155748 A1.

The solutions according to the above documents do not, however, enable solving of the problems as explained in the beginning.

It is the aim of the method according to the present invention to achieve a decisive improvement in the problems described above and thus to raise essentially the level of prior art. In order to carry out this aim, the method according to the invention is mainly characterized by that the actuator arrangement and the frame part are being coupled with each other in an integral manner by processing a manufacturing material forming the frame part in connection with the actuator arrangement.

As the most important advantages of the method may be mentioned simplicity and efficiency of the method itself and the actuators to be manufactured by the same, in which case a totally new kind of an actuator is made possible by exploiting a very usual processing as such, whereby the actuator has its electric actuator arrangement and thermally conductive and, when needed, electrically non-conductive frame part built together from manufacturing onwards. Thus a manual manufacturing of a LED light source e.g. as described in the beginning, can be avoided along with use of an extraordinary thermally conductive tape or paste that is usually needed in this context.

When applying the method according to the invention advantageously, a manufacturing material forming the frame part is being processed in connection with the actuator arrangement by exploiting mold technique, whereby the actuator arrangement is being sunk by its heat sensitive or thermally conductive surface at least partly inside the frame part. Thus, as a particularly advantageous embodiment particularly in putting together of a LED light source, at a bottom of the LED is being processed advantageously furthermore an at least thermally conductive composite material that is based on rubber and/or plastic, whereby thanks to its thermal transmission properties also heat strain directed to the LED component during the processing can be kept adequately low. When exploiting the method advantageously further, the actuator arrangement is being coupled with electronics operating the same at least partly internally in the frame part by exploiting in the processing an essentially electrically non-conductive manufacturing material, which for its part minimizes significantly manufacturing costs.

The method according to the invention enables thus both technically and economically taken remarkable advantages when compared e.g. to the present manual manufacturing of LED light sources. The invention enables furthermore manufacturing of very accurate measured actuators that have furthermore a freedom in shape, whereby an advantage of the actuators is in addition to lightness, a finished appearance thereof from the manufacturing onwards as well as good dampproofness characteristics.

Other advantageous embodiments of the method according to the invention have been presented in the dependent claims related thereto.

In the following description, the invention is being illustrated in detail with reference to the appended drawings, in which
- in figures 1a - 1d: are shown as exemplary cross sectional views two alternative compositions of a traditionally manufactured LED light source (figures 1a & 1b), and as a front view and as a side view two traditional LED-components (figures 1c & 1d),
- in figures 2a and 2b: is shown an advantageous actuator being enabled by the method according to the invention, such as a LED light source being manufactured by the method and being put together in two alternative ways,
- in figures 3a - 3h: are shown some advantageous actuator compositions being based on the LED component shown in figure 1c and manufactured by the method according to the invention as alternative embodiments in respect with the ones shown in figures 2a and 2b,
- in figures 4a - 4b: is shown an actuat or based on the LED component according to figure 1d as two alternative compositions, and furthermore is shown
- in figures 5a - 5c: are shown corresponding cross sectional views of three alternative compositions enabled by the method according to the invention, the compositions containing several electric actuator arrangements.

The invention relates to a method for manufacturing of an electric actuator, which actuator consists of an electric actuator arrangement 1 that is sensible to heat and/or that generates heat, the actuator being put together to form a uniform organ, such as a light source, by coupling the electric actuator arrangement with an at least thermally conductive frame part 2. The actuator arrangement 1 and the frame part 2; 2' are being coupled with each other in an integral manner by processing a manufacturing material forming the frame part 2; 2' in connection with the actuator arrangement 1.

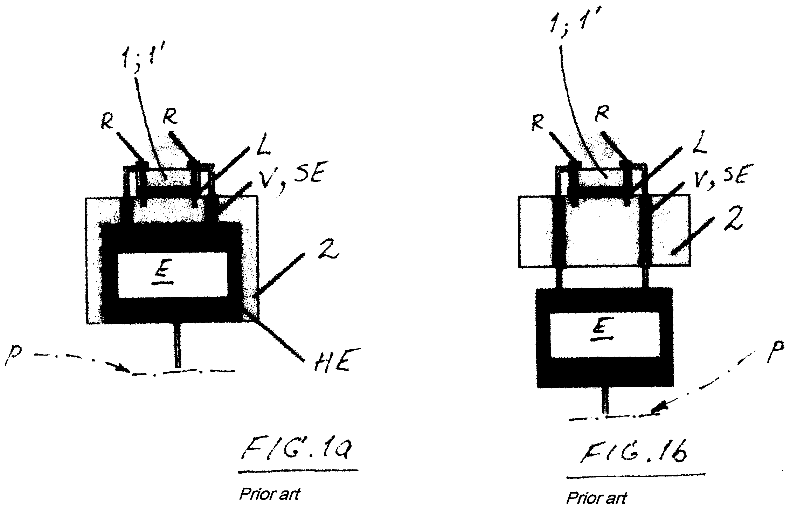

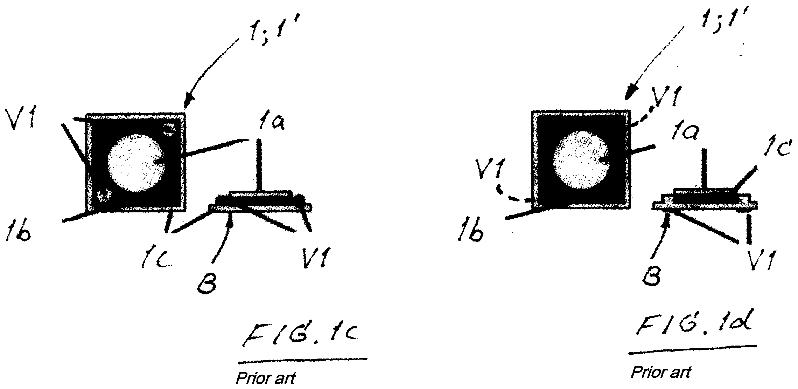

In figures 1a and 1b is shown a usual LED light source, being put together by a traditional method manually, in which a LED component 1; 1', as shown particularly in figure 1c, that consists of an aluminium frame 1c, being equipped with contact surfaces V1 on its upper surface 1b that has an electrically insulating surface treatment, and a diode 1a, the LED component being coupled in the composition according to figure 1a by a screw joint R with an aluminium frame 2, inside of which is arranged in an integral and screened HE manner electronics E operating the LED component, whereby the electronics gets its current from a power source P. In the implementation according to figure 1a, the contact surfaces V1 of the LED-component 1; 1' are connected inside the aluminium frame 2 by electrically insulated SE conductors V with the electronics unit E. In the composition according to figure 1b, there has been exploited for its part a separate electronics unit E in respect with the aluminium frame 2. In figure 1d is shown an alternative LED light source with respect to the one shown in figure 1c, in which the contact surfaces V1 are at the bottom surface of the LED component 1; 1'.

As an advantageous embodiment of the method according to the invention, the manufacturing material forming the frame part 2; 2' is being processed in connection with the actuator arrangement 1 by exploiting mold technique.

Furthermore, as an advantageous embodiment of the method, the actuator arrangement 1 is being processed in connection with the manufacturing of the actuator particularly by its heat sensitive and/or heat generating surface B to be at least partly sunk inside the frame part 2', which manifests itself from all of the appended exemplary drawings presenting actuators that are manufactured by the method according to the invention.

Furthermore as an advantageous embodiment of the method, as the manufacturing material of the frame part 2; 2' or as a part thereof is being used thermosetting plastic, thermoplastic, vulcanized rubber and/or thermoplastic elastomer, which is being processed in connection with the actuator arrangement 1 by injection molding, die-casting or in a corresponding manner.

When the electric actuator assembly 1 comprises one or several heat generating electric actuators, such as LED components 1' or like as presented in the appended drawings, at the bottom B thereof is being processed advantageously furthermore an at least thermally conductive composite material that is based on rubber and/or plastic.

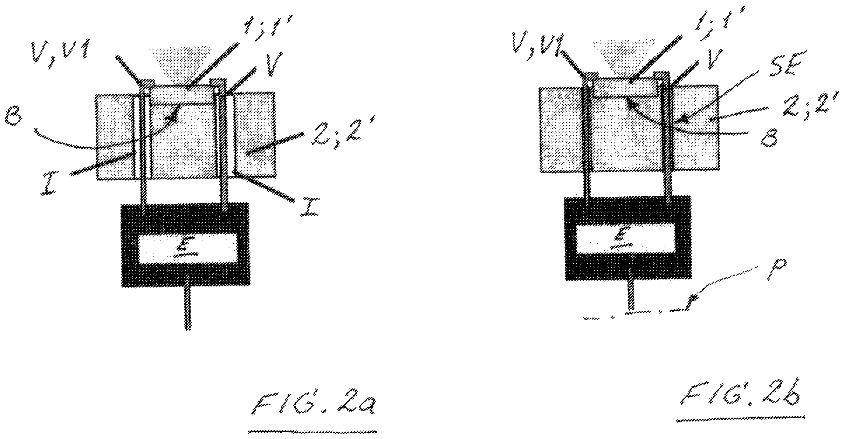

In connection with the LED light source 1; 1', 2 presented in figures 1a and 1b, being based on manual manufacturing, there has been exploited electronics E, being coupled in an integral manner with the frame part, as explained above, and also on the other being apart from the frame part, the electronics being coupled with the LED component electrically. When applying the method according to the invention, a corresponding composition can be carried out by using thermally conductive plastic based manufacturing material forming the frame part 2; 2' e.g. on the principles presented in figures 2a and 2b, in which case due to a more or less electrically conductive frame part 2', the conductors V, connecting the LED component 1' and the electronics E operating the same, exist in an air space I in the frame part or the conductors being coated or covered by an electrically insulating material SE.

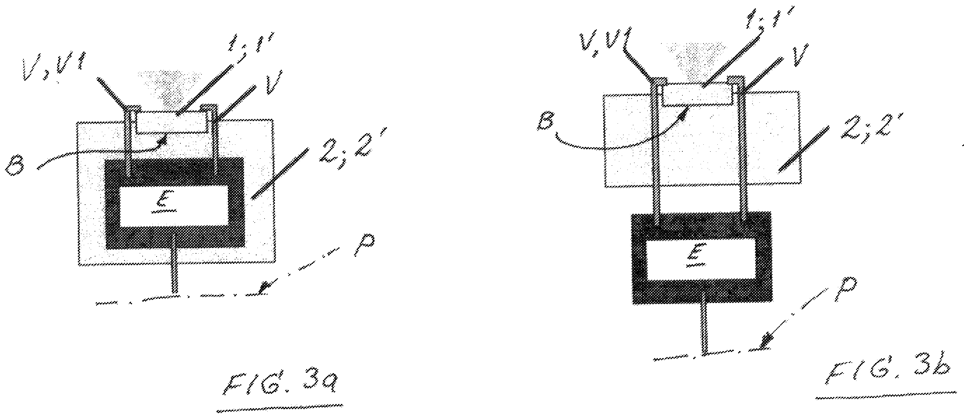

Particularly, as an alternative embodiment of the method with respect to the one described above, with reference e.g. to the compositions presented e.g. in figures 3a - 3h, the actuator arrangement 1 is being coupled with the electronics E operating the same at least partly internally inside the plastic based frame part 2' by using in the processing an essentially electrically non-conductive manufacturing material, such as a manufacturing material containing e.g. ceramic, organic and/or mineral based substance.

As a further advantageous embodiment of the method in this context, the electrical conductors V and/or the electronics E, being coupled with the actuator arrangement 1 are being processed in an integral manner inside the frame part 2', in which case there is no need for the protective insulation in the first place.

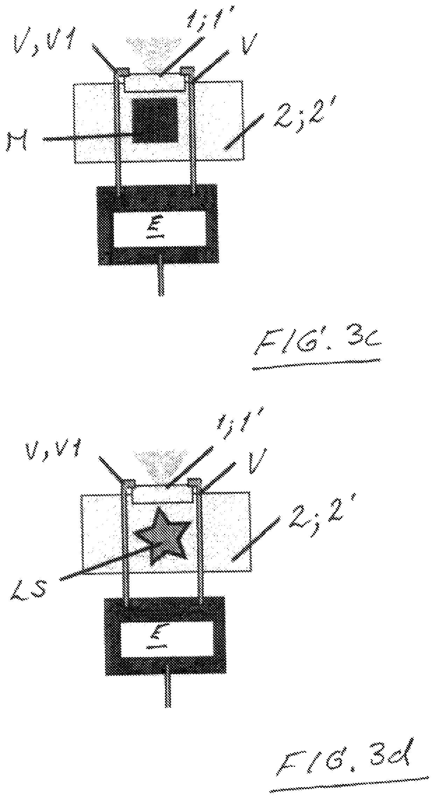

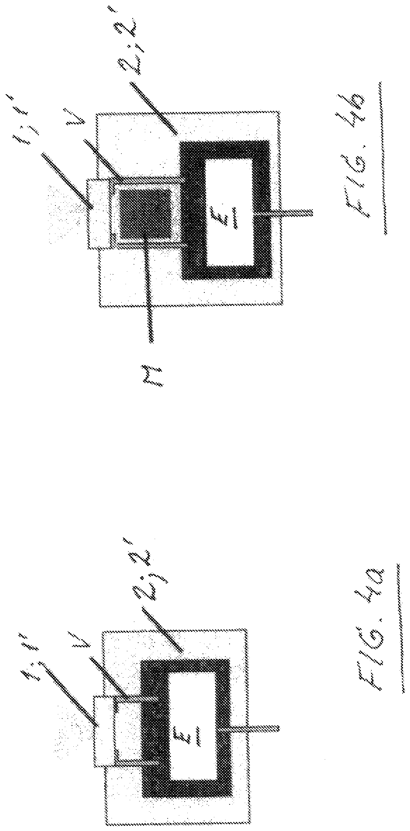

Furthermore as an advantageous embodiment of the method, particularly with reference to the compositions presented in figures 3c and 4b, in connection with the processing, a cooling insert M made of metal, such as aluminium, is being installed inside the frame part 2; 2'. In this way it is possible to improve furthermore the thermal transmission/cooling properties of the frame part 2'.

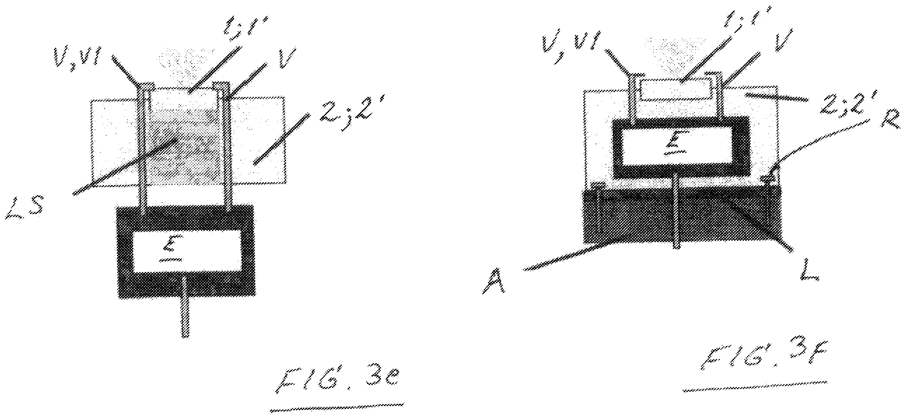

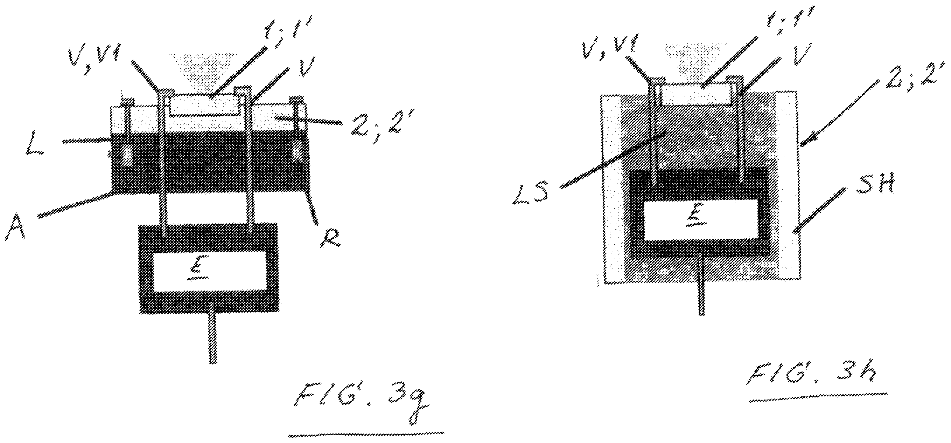

Furthermore as an advantageous embodiment of the method, a two- or multi-component manufacturing is being exploited in the processing e.g. in order to achieve different parts of the frame part 2' to have thermal conductivity and/or electrical conductivity characteristics deviating from each other or for corresponding purpose. In the appended drawings, in the manufacturing of the compositions according to figures 3d and 3e, there has been applied the technique above by a material zone LS, being processed inside the frame part 2' that makes thermal transmission more efficient. Accordingly, in the composition according to figure 3h, there has been processed in this way in the center part of the frame part 2' a material zone LS that is thermally non-conductive and possibly also electrically non-conductive, in which case on the outer surface of the frame part there has been processed a material zone SH comprising cheaper customary plastics.

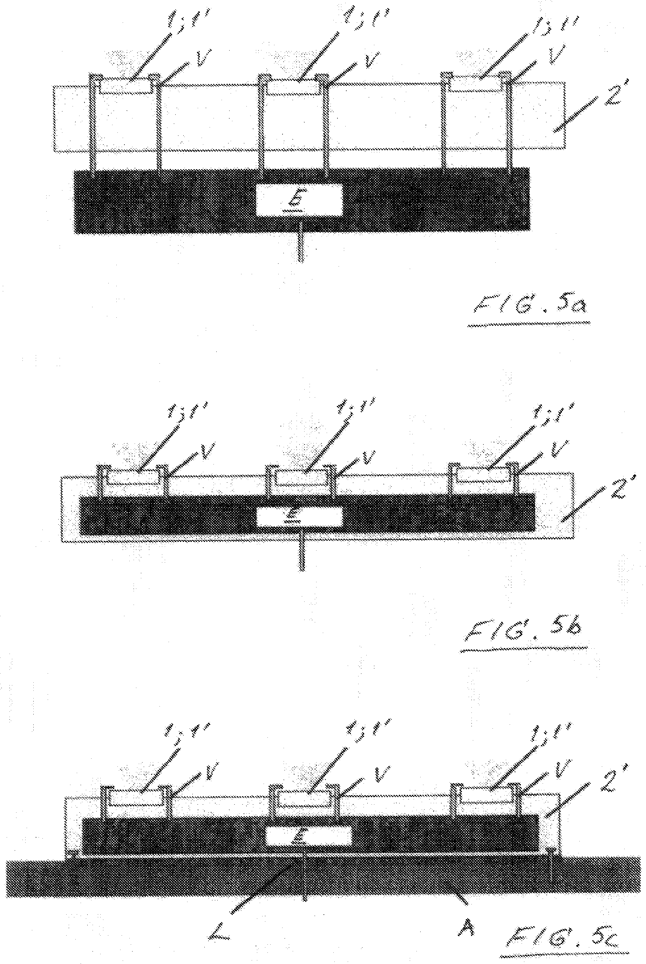

In connection with an actuator being manufactured according to the method, it is furthermore possible to exploit implementations known as such from prior art e.g. on the principles presented e.g. in figures 3f, 3g and 5c, in which case in connection with an actuator 1; 2', being manufactured by the method according to the invention, is being coupled e.g. by a screw joint R possibly together with a thermally conductive paste or a tape layer L a metallic installation rail A e.g. made of aluminium, which for its part makes thermal transmission thus even more efficient.

The compositions presented in figures 4a and 4b are manufactured by using a LED component 1' according to figure 1d, in which the contact surfaces V1 are at the bottom surface of the component. In this kind of an implementation, an optimum composition is achieved particularly with a view to its moisture isolation characteristics, because all electrical operations of the actuator are thus closed inside the frame part 2' in a totally protected manner during the manufacturing process of the actuator. Furthermore in figures 5a and 5c are presented light units consisting of several LEDs 1', in which there has been used either external or integral electronics E. This kind of a lighting unit can be coupled by customary screw joints R as such e.g. on the principle shown in figure 5c and, when needed, by using a thermally insulating paste or tape L, with an actual installation rail A.

It is clear that the invention is not limited to the embodiments presented or described above, but instead it can be modified within the basic idea of the invention in very many ways. It is thus first of all clear that the method according to the invention can be exploited in manufacturing of actuators containing most heterogeneous electrical components, when there is a need to couple particularly an electrical actuator with a thermally conductive frame part in an integral manner. It is thus clear that the electric actuator does not need to generate heat as such, but instead it can be merely sensitive to heat, so that it does not forfeit its characteristics due to excessive heat, when it is being soldered or processed according to the invention. The method according to the invention can thus also be exploited in connection with production of other types of light sources as well as in connection with most heterogeneous heat generating electrical components, such as electric circuits, microprocessors etc. The method according to the invention can also be varied with a view to manufacturing techniques by exploiting differing manufacturing processes e.g. depending on the manufacturing materials, such as e.g. powder technique, melt processing technique etc.

## Claims

1. Method for manufacturing of an electric actuator, which electric actuator consists of an electric actuator arrangement (1), being sensible to heat and/or generating heat and comprising one or several light emitting electric actuators, such as LEDs (1a), the electric actuator being put together to form a uniform light source, and comprising a frame part (2; 2') that exists against a heat exchange surface (B) of the electric actuator arrangement (1), and wherein the light emitting electric actuators comprise thermosetting plastic, thermoplastic, vulcanized rubber and/or thermoplastic elastomer, **characterized in that**, in production of the electric actuator that is meant for use in LED-lighting/light production an electrical conductor arrangement (1b) and electronics (E), being coupled with the electric actuator arrangement (1) to operate the same, are being processed in an integral manner inside the frame part (2; 2'), being formed by injection molding or die-casting thermosetting plastic, thermoplastic, vulcanized rubber and/or thermoplastic elastomer in connection with the electric actuator arrangement (1).

2. Method according to claim 1, **characterized in that**, the actuator arrangement (1) is being coupled with the electronics (E) at least partly internally in the frame part (2; 2') by exploiting in the processing an essentially electrically non-conductive manufacturing material.

3. Method according to claim 2, **characterized in that**, in the processing a manufacturing material is being exploited that comprises an electrically non-conductive ceramic, organic and/or mineral based substance.

4. Method according to any of the preceding claims 1-3, **characterized in that**, in connection with the processing, a cooling insert, preferably made of metal, is being installed inside the frame part (2; 2').

5. Method according to any of the preceding claims 1-4, **characterized in that**, a two- or multi-component manufacturing is being exploited in the processing particularly in order to achieve different parts of the frame part (2; 2') to have thermal conductivity characteristics deviating from each other.

6. Method according to any of the preceding claims 1-5, **characterized in that**, a two- or multi-component manufacturing is being exploited in the processing particularly in order to achieve different parts of the frame part (2; 2') to have electrical conductivity characteristics deviating from each other.

## Patentansprüche

1. Verfahren zur Herstellung eines elektrischen Aktuators, der aus einer elektrischen Aktuatoranordnung (1) besteht, die wärmeempfindlich ist und/oder Wärme erzeugt und einen oder mehrere lichtemittierende elektrische Aktuatoren, wie LEDs (1a), umfasst, wobei der elektrische Aktuator zu einer einheitlichen Lichtquelle zusammengesetzt ist und ein Rahmenteil (2; 2') umfasst, das an einer Wärmeaustauschfläche (B) der elektrischen Aktuatoranordnung (1) anliegt, und wobei die lichtemittierenden elektrischen Aktuatoren duroplastischen Kunststoff, thermoplastischen Kunststoff, vulkanisierten Kautschuk und/oder thermoplastisches Elastomer umfassen, **dadurch gekennzeichnet, dass** bei der Herstellung des elektrischen Aktuators, der für die Verwendung in der LED-Beleuchtung/Lichterzeugung bestimmt ist, eine elektrische Leiteranordnung (1b) und eine Elektronik (E), die mit der elektrischen Aktuatoranordnung (1) zu deren Betrieb gekoppelt ist, auf integrale Weise innerhalb des Rahmenteils (2; 2') verarbeitet werden, das durch Spritz- oder Druckguss von Duroplast, Thermoplast, vulkanisiertem Kautschuk und/oder thermoplastischem Elastomer in Verbindung mit der elektrischen Aktuatoranordnung (1) gebildet wird.

2. Verfahren nach Anspruch 1, **dadurch gekennzeichnet, dass** die Aktuatoranordnung (1) mit der Elektronik (E) zumindest teilweise intern im Rahmenteil (2; 2') gekoppelt wird, indem bei der Verarbeitung ein im Wesentlichen elektrisch nicht leitendes Fertigungsmaterial genutzt wird.

3. Verfahren nach Anspruch 2, **dadurch gekennzeichnet, dass** bei der Verarbeitung ein Fertigungsmaterial verwendet wird, das eine elektrisch nicht leitende Substanz auf keramischer, organischer und/oder mineralischer Basis umfasst.

4. Verfahren nach einem der vorhergehenden Ansprüche 1 bis 3, **dadurch gekennzeichnet, dass** im Zusammenhang mit der Verarbeitung ein Kühleinsatz, vorzugsweise aus Metall, in das Rahmenteil (2; 2') eingebaut wird.

5. Verfahren nach einem der vorhergehenden Ansprüche 1 bis 4, **dadurch gekennzeichnet, dass** bei der Verarbeitung eine Zwei- oder Mehrkomponentenfertigung genutzt wird, um insbesondere zu erreichen, dass verschiedene Teile des Rahmenteils (2; 2') voneinander abweichende Wärmeleitfähigkeitseigenschaften aufweisen.

6. Verfahren nach einem der vorhergehenden Ansprüche 1 bis 5, **dadurch gekennzeichnet, dass** bei der Verarbeitung eine Zwei- oder Mehrkomponentenfertigung genutzt wird, um insbesondere zu erreichen, dass verschiedene Teile des Rahmenteils (2; 2') voneinander abweichende elektrische Leitfähigkeitseigenschaften aufweisen.

## Revendications

1. Procédé de fabrication d'un actionneur électrique, lequel actionneur électrique se compose d'un dispositif d'actionneur électrique (1), étant sensible à la chaleur et/ou générant de la chaleur et comprenant un ou plusieurs actionneurs électriques émettant de la lumière, tels que LED (la), l'actionneur électrique étant assemblé pour former une source de lumière uniforme, et comprenant une partie de cadre (2; 2') existant contre une surface d'échange de chaleur (B) du dispositif d'actionneur électrique (1), et où les actionneurs électriques émettant de la lumière comprennent du plastique thermodurcissable, du thermoplastique, du caoutchouc vulcanisé et/ou de l'élastomère thermoplastique, **caractérisé par le fait que**, dans la production de l'actionneur électrique destiné à être utilisé dans la production d'éclairage/lumière LED, un dispositif de conducteur électrique (1b) et l'électronique (E) accouplée au dispositif d'actionneur électrique (1) pour le commander, sont traités de manière intégrale à l'intérieur de la partie de cadre (2; 2'), formée de plastique thermodurcissable moulé par injection ou coulé sous pression, thermoplastique, caoutchouc vulcanisé et/ou élastomère thermoplastique en connexion avec le dispositif d'actionneur électrique (1).

2. Procédé décrit dans la revendication 1, **caractérisé par le fait que** le dispositif d'actionneur (1) est accouplé à l'électronique (E) au moins partiellement à l'intérieur dans la partie de cadre (2; 2') en exploitant dans le traitement un matériau de fabrication essentiellement non électroconducteur.

3. Procédé décrit dans la revendication 2, **caractérisé par le fait que**, dans le traitement, un matériau de fabrication est exploité comprenant substance non électroconductrice à base céramique, organique et/ou minérale.

4. Procédé décrit dans une quelconque des revendications précédentes 1-3, **caractérisé par le fait que**, en relation avec le traitement, un élément de refroidissement, de préférence en métal, est inséré dans la partie de cadre (2; 2').

5. Procédé décrit dans une quelconque des revendications précédentes 1-4, **caractérisé par le fait qu'**une fabrication à deux ou plusieurs composants est exploitée dans le traitement, en particulier pour faire en sorte que différentes parties de la partie de cadre (2; 2') aient des caractéristiques thermoconductrices différentes les unes des autres.

6. Procédé décrit dans une quelconque des revendications précédentes 1-5, **caractérisé par le fait qu'**une fabrication à deux ou plusieurs composants est exploitée dans le traitement, en particulier pour faire en sorte que différentes parties de la partie de cadre (2; 2') aient des caractéristiques électroconductrices différentes les unes des autres.
